(19) **Europäisches Patentamt**
**European Patent Office**
**Office européen des brevets**

(11) **EP 4 270 031 B1**

(12) **FASCICULE DE BREVET EUROPEEN**

(45) Date de publication et mention
de la délivrance du brevet:
**25.12.2024 Bulletin 2024/52**

(21) Numéro de dépôt: **23170495.8**

(22) Date de dépôt: **27.04.2023**

(51) Classification Internationale des Brevets (IPC):
***G01R 31/389*** *(2019.01)* ***H01M 8/04537*** *(2016.01)*
***H01M 8/0432*** *(2016.01)* ***H01M 8/10*** *(2016.01)*

(52) Classification Coopérative des Brevets (CPC):
**G01R 31/389; H01M 8/04365; H01M 8/04552;**
**H01M 8/04559; H01M 8/04589; H01M 8/04641;**
**H01M 8/04649;** H01M 2008/1095

(54) **DISPOSITIF ET PROCÉDÉ DE DÉTERMINATION DE L'ÉTAT DE SANTÉ D'UNE PILE À COMBUSTIBLE**

VORRICHTUNG UND VERFAHREN ZUR BESTIMMUNG DES GESUNDHEITSZUSTANDES EINER BRENNSTOFFZELLE

DEVICE AND METHOD FOR DETERMINING THE STATE OF HEALTH OF A FUEL CELL

(84) Etats contractants désignés:
**AL AT BE BG CH CY CZ DE DK EE ES FI FR GB**
**GR HR HU IE IS IT LI LT LU LV MC ME MK MT NL**
**NO PL PT RO RS SE SI SK SM TR**

(30) Priorité: **28.04.2022 FR 2204022**

(43) Date de publication de la demande:
**01.11.2023 Bulletin 2023/44**

(73) Titulaire: **Commissariat à l'Energie Atomique et aux Energies Alternatives**
**75015 Paris (FR)**

(72) Inventeur: **RANIERI, Marco**
**38054 Grenoble cedex 09 (FR)**

(74) Mandataire: **Hautier IP**
**20, rue de la Liberté**
**06000 Nice (FR)**

(56) Documents cités:
**CN-A- 111 077 467** US-A1- 2007 259 256
US-A1- 2016 054 391

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

**DOMAINE TECHNIQUE**

La présente invention concerne la détermination de l'impédance des étages d'une pile à combustible, et plus particulièrement d'une pile à hydrogène. Elle permet de déterminer l'état de santé d'une telle pile.

**ETAT DE LA TECHNIQUE**

Une pile à combustible a une structure en empilement de plaques métalliques, dites bipolaires, intercalées avec des membranes. Chaque paire de plaques, avec la membrane au milieu, est une couche ou étage, comprenant une électrode positive et une négative (anode et cathode) présentant un potentiel électrique lors du fonctionnement de la pile. La partie la plus délicate et cruciale pour les performances de la pile à combustible et pour sa longévité est en particulier la membrane, appelée également membrane PEM (« Proton Exchange Membrane» en langue anglaise), c'est-à-dire la membrane d'échange de protons d'une cellule à combustible. Pour une pile à hydrogène, la membrane constitue l'interface qui permet la réaction électrochimique entre l'oxygène et l'hydrogène produisant un courant électrique, notamment grâce à la présence d'un catalyseur. Si la membrane est trop sèche (accumulation de gaz inerte en son sein), ou au contraire si elle est trop humide (accumulation d'eau en son sein), ses performances, ainsi que les performances de la pile seront dégradées, avec une possible réduction de sa durée de vie.

Plusieurs modèles représentatifs d'une pile à combustible existent, souvent à éléments discrets et capables de fournir une estimation de l'état de santé de la pile, et notamment de ses membranes. Ces modèles se basent très souvent sur une mesure de l'impédance électrique de la pile et de chacun de ses étages, à l'aide d'algorithmes de filtrage qui s'appuient sur les mesures de courant total et de tensions des étages de la pile obtenues lors de son fonctionnement normal. Afin de pouvoir exploiter ces modèles, il est nécessaire de connaître l'impédance de la pile, ou d'un étage de la pile, et plus particulièrement de connaître la résistance de la membrane à une fréquence précise, souvent égale à 1 kHz. En effet, l'impédance est la donnée d'entrée des modèles représentatifs de l'état de santé de la membrane et donc de la pile, et il est donc nécessaire de mesurer l'impédance, en particulier à 1 kHz, de chaque étage de la pile. Il est à noter qu'une mesure d'impédance à 1 kHz, ou à une autre fréquence requise par les algorithmes d'état, permet de déterminer un état de santé pertinent de la pile.

Il existe des composants électroniques de mesure de tension, mais en général leur fréquence d'échantillonnage n'est pas suffisante pour mesurer une impédance à 1 kHz.

D'autres dispositifs permettent de mesurer l'impédance d'une pile et de ses étages lors de son assemblage. Mais il s'agit d'instruments de laboratoire dédiés utilisés seulement après la mise en gaz de la pile, c'est-à-dire avant d'embarquer la pile dans un système, notamment un véhicule mobile. Ces instruments ne sont pas adaptés pour être transportés, ni pour être intégrés dans un appareil de diagnostique portatif.

On peut citer par exemple, la demande de brevet chinois CN 109 916 964, qui divulgue un procédé dans lequel on sélectionne plusieurs gaz ayant différentes humidités afin de purger une pile à combustible et obtenir différentes résistances internes de la pile. Mais ce procédé n'est pas adapté pour mesurer l'impédance d'une pile en fonctionnement, notamment une pile embarquée au sein d'un système, par exemple un véhicule mobile.

On peut également citer la demande de brevet américain US 2019 049522, qui divulgue une estimation d'un état de santé (SOH, pour « State of Health » en langue anglaise) d'une pile à combustible, en appliquant un courant, ou une tension, d'excitation à toute la pile afin de déterminer un facteur de distorsion harmonique d'un signal résultant en tension, ou en courant. En outre, le procédé peut utiliser un modèle pour connaître l'état de santé de la pile. Mais le procédé ne permet pas de mesurer une impédance d'un étage en particulier. Il ne s'affranchit pas non plus des erreurs de mesure.

On peut citer la demande de brevet américain US 2010 323260, qui divulgue un procédé dans lequel on stocke en mémoire une valeur d'impédance mesurée au préalable sur une pile à combustible quand elle n'est pas en fonctionnement. Puis, on mesure l'impédance de la pile et on compare la valeur mesurée avec l'impédance de référence stockée en mémoire afin d'estimer une quantité d'eau présente dans le système. Le procédé ne permet pas non plus de connaître l'état de la membrane d'un étage de la pile. Il ne s'affranchit pas non plus des erreurs de mesure, notamment des erreurs de mesure sur l'impédance de la pile.

On peut également citer la demande de brevet chinois CN 111077467A, qui divulgue un système de mesure de l'impédance pour les piles à combustible à membrane d'échange de protons.

Un objet de la présente invention est donc de proposer des moyens pour améliorer l'estimation de l'état de santé d'une pile.

Un autre objet consiste à fournir des moyens pour estimer l'état de santé de la pile lorsque cette dernière est en fonctionnement pour produire une énergie électrique.

Un autre objet consiste à fournir des moyens simples à réaliser et à mettre en oeuvre.

Les autres objets, caractéristiques et avantages de la présente invention apparaîtront à l'examen de la description suivante et des dessins d'accompagnement. Il est entendu que d'autres avantages peuvent être incorporés.

**RESUME**

Pour atteindre cet objectif, selon un mode de réalisation, on prévoit un dispositif de détermination d'impédance d'une pluralité d'étages d'une pile à combustible, chaque étage de la pluralité d'étages comprenant un électrolyte placé entre deux électrodes, le dispositif comprenant :

- plusieurs circuits de connexion associés respectivement aux étages de la pluralité d'étages, chaque circuit de connexion étant électriquement couplé aux électrodes de l'étage associé, et
- un système de mesure comprenant un système d'excitation commun à la pluralité d'étages, et des moyens de sélection.

Le système de mesure comporte un circuit, dit circuit équivalent, ayant une impédance de référence correspondant à celle d'un étage de la pluralité d'étages, et les moyens de sélection sont aptes à sélectionner un étage de la pluralité d'étages en couplant électriquement le circuit de connexion associé avec le système d'excitation, les moyens de sélection étant en outre aptes à sélectionner le circuit équivalent en couplant électriquement le circuit équivalent avec le système d'excitation, et le système de mesure est configuré pour :

- appliquer à l'étage sélectionné un signal d'excitation généré par le système d'excitation ;
- mesurer un signal de réponse de l'étage sélectionné à l'application du signal d'excitation ;
- appliquer au circuit équivalent un signal d'excitation généré par le système d'excitation ;
- mesurer un signal de réponse du circuit équivalent à l'application du signal d'excitation ;
- déterminer une impédance du circuit équivalent à partir du signal de réponse du circuit équivalent ;
- calculer une erreur d'impédance à partir de l'impédance de référence et de l'impédance déterminée du circuit équivalent, et
- déterminer une impédance de l'étage sélectionné à partir du signal de réponse de l'étage sélectionné et de l'erreur d'impédance.

Ainsi, le dispositif permet de déterminer une impédance de chacun des étages de la pluralité d'étages et de préférence de tous les étages de la pile.
La détermination de l'impédance d'un étage permet de déterminer des informations relatives à l'état de santé de l'étage, et donc de la pile, comme par exemple une variation de la résistance de l'électrolyte.
Un tel dispositif est particulièrement peu encombrant et peut être facilement intégré au sein d'un système où est embarquée la pile, notamment un système mobile.
Selon un autre aspect, il est proposé un assemblage, comprenant :

- une pile à combustible comprenant une pluralité d'étages, chaque étage de la pluralité d'étages comprenant un électrolyte placé entre deux électrodes ; et
- un dispositif de détermination de l'impédance de la pluralité d'étages de la pile à combustible tel que défini ci-avant.

Selon un autre aspect, il est proposé un procédé de détermination d'impédance d'une pluralité d'étages d'une pile à combustible, chaque étage de la pluralité d'étages comprenant un électrolyte placé entre deux électrodes.
Le procédé comprend :

- une première mesure comportant :

  ◦ une sélection d'un étage en couplant électriquement les électrodes de l'étage avec un système d'excitation commun à la pluralité d'étages ;
  ◦ une application à chaque étage sélectionné d'un signal d'excitation généré par le système d'excitation ; et
  ◦ une mesure d'un signal de réponse de l'étage sélectionné à l'application du signal d'excitation ;

- une deuxième mesure effectuée avant ou après la première mesure, la deuxième mesure comportant :

  ◦ une sélection d'un circuit, dit circuit équivalent, ayant une impédance de référence correspondant à celle d'un étage de la pluralité d'étages, en couplant électriquement le circuit équivalent avec le système d'excitation ;
  ◦ une application au circuit équivalent d'un signal d'excitation généré par le système d'excitation ; et

∘ une mesure d'un signal de réponse du circuit équivalent à l'application du signal d'excitation ;

le procédé comprenant, en outre :

- une détermination d'une impédance du circuit équivalent à partir du signal de réponse du circuit équivalent ;
- un calcul d'une erreur d'impédance à partir de l'impédance de référence et de l'impédance déterminée du circuit équivalent, et
- une détermination d'une impédance de l'étage sélectionné à partir du signal de réponse de l'étage sélectionné et de l'erreur d'impédance.

## BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

La figure 1 représente de façon schématique un mode de réalisation d'un dispositif de détermination d'impédance.
La figure 2 représente de façon schématique un mode de réalisation d'un système d'excitation.
La figure 3 représente schématiquement un mode de réalisation d'un circuit équivalent.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques.

## DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :

- Selon un exemple, le système de mesure comprend une unité de commande électronique et les moyens de sélection comprennent au moins un multiplexeur commandé par l'unité de commande électronique.
- Selon un exemple, le circuit électrique équivalent comprend un ensemble de composants ayant pour impédance, l'impédance de référence, et une source de tension pour alimenter l'ensemble de composants, la source de tension fournissant une tension équivalente à celle fournie par un étage.
- Selon un exemple, le système de mesure est configuré pour déterminer l'impédance d'un étage sélectionné périodiquement selon une première période et pour déterminer l'impédance du circuit équivalent périodiquement selon une deuxième période inférieure ou égale à la première période.
- Selon un exemple, le système de mesure est localisé à un emplacement tel qu'une température de l'emplacement diffère de moins de 30°C et de préférence de moins de 10°C, d'une température de la pile à combustible lors de son fonctionnement.
- Selon un exemple, le système de mesure comprend un capteur de température apte à mesurer la température de la pile à combustible, notamment en mesurant la température à proximité ou celle du liquide de refroidissement en sortie de la pile.
- Selon un exemple, les deux éléments électriquement conducteurs empruntent au moins partiellement une zone où sont situés les deux fils électriquement conducteurs d'au moins un circuit de connexion.
- Selon un exemple, le système de mesure est imprimé sur une carte de circuits imprimés.
- Selon un exemple, le système de mesure est alimenté par une source d'alimentation indépendante de la pile à combustible.
- Selon un exemple, le signal d'excitation a une fréquence comprise entre 0,1 Hz et 10000Hz, de préférence comprise entre 100Hz et 5000Hz, de préférence égale à 1000Hz.
- Selon un autre exemple, chaque circuit de connexion comprend deux fils électriquement conducteurs couplés aux moyens de sélection et le circuit électrique équivalent comprend deux éléments électriquement conducteurs couplés aux moyens de sélection, l'impédance de chacun des deux éléments étant comprise entre 0,9 fois et 1,1 fois celle de chacun des deux fils des circuits de connexion.
- Selon un autre exemple, la section et la longueur de chacun des deux éléments est comprise entre 0,9 fois et 1,1 fois, de préférence identique, à celles de chacun des deux fils des circuits de connexion.
- Selon un autre exemple, la pluralité d'étages correspond à l'intégralité des étages de la pile à combustible. Ainsi, le dispositif permet de mesurer l'impédance de chaque étage de la pile à combustible.

- Selon un autre exemple, le dispositif comprend un unique système d'excitation pour la pluralité d'étages, de préférence un unique circuit d'excitation pour l'intégralité des étages de la pile à combustible.
- Selon un autre exemple, le système de mesure est en outre configuré pour déterminer l'impédance de l'étage sélectionné lorsque la pile à combustible fournit une énergie électrique.
- Selon un exemple, l'électrolyte est une membrane d'échange de protons.
- Selon un autre exemple, le procédé comprend une alimentation du circuit équivalent par une source d'alimentation indépendante de la pile à combustible.
- Selon un autre exemple, le procédé comprend une détermination périodique, selon une première période, de l'impédance d'un étage sélectionné et une détermination périodique, selon une deuxième période inférieure ou égale à la première période, de l'impédance du circuit équivalent.
- Selon un autre exemple, la pile à combustible produit de l'énergie électrique.

Il est précisé que dans le cadre de la présente invention, l'expression « A couplé électriquement à B » ou « A couplé à B » ou « A connecté à B » est synonyme de « A est en connexion électrique avec B » et ne signifie pas nécessairement qu'il n'existe pas d'organe entre A et B. Ainsi ces expressions s'entendent d'une connexion électrique entre deux éléments, cette connexion pouvant ou non être directe, cela signifie qu'il est possible qu'entre un premier dispositif A et un deuxième dispositif B qui sont électriquement connectés, un courant circule en A, en B, et sur le parcours reliant A à B, ce parcours pouvant ou non comprendre d'autres équipements électriques.

A l'inverse, dans le cadre de la présente invention, le terme «électriquement connecté directement» s'entend d'une connexion électrique directe entre deux éléments. Cela signifie qu'entre un premier dispositif A et un deuxième dispositif B qui sont électriquement connectés directement aucun autre équipement n'est présent, autre qu'une connexion électrique ou plusieurs connexions électriques.

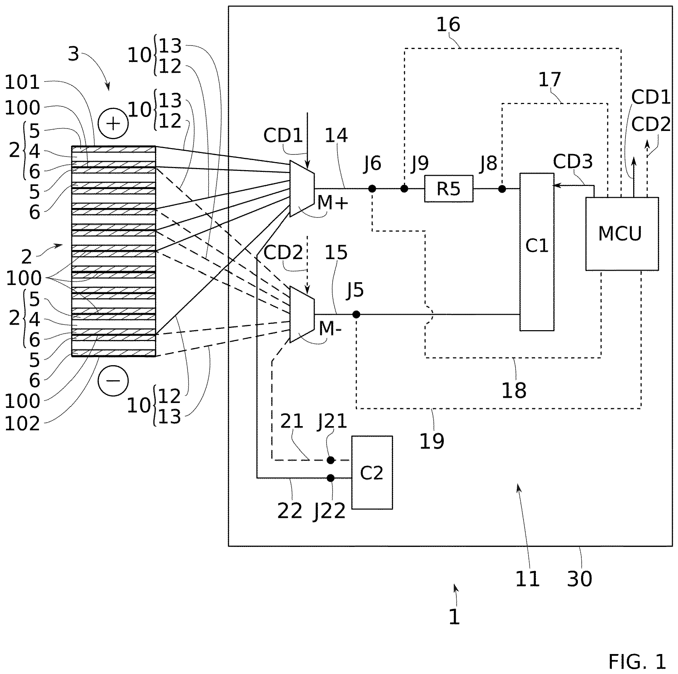

Sur la figure 1, on a représenté un dispositif 1 de détermination d'impédance d'une pluralité d'étages 2 d'une pile à combustible 3. Une pile à combustible 3 est un système de génération d'une tension électrique grâce à une oxydation sur une électrode d'un combustible réducteur couplée à la réduction sur l'autre électrode d'un oxydant. En particulier, le dispositif 1 vise les piles à hydrogène, pour lesquelles le combustible réducteur est le dihydrogène et l'oxydant est l'oxygène. Chaque étage 2 de la pile 3 comprend un électrolyte 4 placé entre deux électrodes 5, 6. L'électrolyte 4, appelé également membrane ou membrane PEM, est une substance conductrice en raison de la présence d'ions mobiles. Dans le cas d'une pile à hydrogène, les ions mobiles sont des ions hydrogènes. Les gaz (hydrogène, oxygène, eau) circulent dans des canaux présents à chaque étage 2 de la pile 3, non représentés ici à des fins de simplification.

Le potentiel électrique d'un étage 2 est compris entre 0,6 V et 1,2 V pour l'étage d'une pile en fonctionnement normal, c'est-à-dire une pile qui produit une énergie électrique. Les électrodes 5, 6 d'un étage 2 forment une paire anode, cathode et permettent de produire une tension, à chaque étage 2 de la pile 3. En d'autres termes, chaque étage 2 comporte une première électrode 5 d'une première polarité et une deuxième électrode 6 d'une deuxième polarité. Dans l'exemple illustré sur la figure 1, la première polarité est supérieure à la deuxième polarité. En général, les électrodes 5, 6 sont partiellement métalliques. Par ailleurs, les électrodes 5, 6 de deux étages 2 adjacents sont au contact de collecteurs électriques typiquement appelés des plaques bipolaires 100 car elles sont au contact d'un côté d'une anode, et de l'autre côté de la cathode d'un étage 2 adjacent. Plus particulièrement, un premier collecteur électrique, appelé également première plaque monopolaire 101, situé à une première extrémité de la pile 3 est au contact d'une seule première électrode 5. Un deuxième collecteur électrique, ou deuxième plaque monopolaire 102, situé à une deuxième extrémité de la pile 3 est au contact d'une seule deuxième électrode 6. Les première et deuxièmes plaques monopolaires 101, 102 sont également appelées plaques terminales. Ces plaques bipolaires 100 et monopolaires 101, 102 sont typiquement des points de connexion pour effectuer des mesures de tension dans la pile 3. A titre d'exemple, on a représenté une pile à combustible 3 comprenant dix étages 2 empilés en série.

Le dispositif 1 comporte des circuits de connexion 10 et un système de mesure 11. Les circuits de connexion 10 sont destinés à coupler électriquement les étages 2 avec le système de mesure 11. Chaque circuit de connexion 10 est donc associé à un étage distinct 2 de la pile 3. Par exemple, le dispositif 1 comprend plusieurs circuits de connexion 10 associés respectivement à certains étages 2 de la pile 3. Avantageusement, le dispositif comporte un circuit de connexion 10 pour chacun de tous les étages 2 de la pile 3. Plus particulièrement, chaque circuit de connexion 10 est électriquement couplé aux électrodes 5, 6 de l'étage 2 auquel il est associé. En particulier, chaque circuit de connexion 10 est électriquement connecté directement aux plaques bipolaires 100 et monopolaires 101, 102 de l'étage 2 auquel il est associé. Par exemple, chaque circuit de connexion 10 comporte deux connexions électriques 12, 13, notées premières et deuxièmes connexions électriques 12, 13, telles que des câbles, des fils ou des bandes électriquement conducteurs, respectivement couplés électriquement aux électrodes 5, 6 d'un étage 2 associé. De préférence, le système de mesure 11 est couplé électriquement à dix étages 2 de la pile à combustible.

Le système de mesure 11 comporte un système d'excitation C1 commun à la pluralité d'étages 2. Par exemple, le dispositif 1 comporte un unique système d'excitation C1 pour la pluralité d'étages 2, avantageusement un unique circuit d'excitation C1 pour l'intégralité des étages 2 de la pile 3. Le système d'excitation C1 est apte à générer un signal d'excitation destiné aux étages 2 de la pile 3. Le signal d'excitation C1 peut être une variation de courant ou de tension. De préférence, le signal d'excitation est une variation de courant. Préférentiellement, le signal d'excitation est un signal sinusoïdal. Le signal d'excitation permet de déterminer l'impédance Zcell d'un étage 2 de la pile 3. Le dispositif 1 est en outre particulièrement adapté pour déterminer l'impédance Zcell de chacun des étages 2 de la pluralité d'étages de la pile 3.

Le système d'excitation C1 a pour fonction de faire subir à un étage sélectionné 2 des variations de courant, ou de tension, en appliquant un signal par exemple sinusoïdal. Le système de mesure 11 permet de déterminer l'impédance Zcell de l'étage 2 sélectionné à une fréquence particulière d'intérêt. En particulier, le signal d'excitation a une fréquence comprise entre 0,1 Hz et 10000Hz, de préférence comprise entre 100Hz et 5000Hz, de préférence égale à 1000Hz.

Pour déterminer l'impédance Zcell d'un étage 2, on applique à l'étage 2 un signal d'excitation à une fréquence f. L'étage 2 subit ainsi une variation de courant à la fréquence f entrainant une variation de tension aux bornes de l'étage 2, c'est-à-dire entre les électrodes 5, 6 de l'étage 2. On mesure un signal en réponse à l'application du signal d'excitation, en mesurant la variation de courant et/ou de la tension, et une valeur d'impédance Zcell est déterminée à partir de la variation de courant et/ou de tension mesurée.

Afin de pouvoir déterminer l'impédance Zcell de chaque étage 2 de la pluralité d'étages, le système de mesure 11 comporte des moyens de sélection M+, M- aptes à sélectionner un étage 2 en couplant électriquement le circuit de connexion 10 associé à l'étage 2 avec le système d'excitation C1. En particulier, les circuits de connexions 10 sont couplés aux moyens de sélection M+, M-, par l'intermédiaire des connexions électriques 12, 13, et chaque moyen de sélection M+, M- est couplé au système d'excitation C1 par une connexion 14, 15. Par exemple, les moyens de connexion M+, M- peuvent être des multiplexeurs. Chaque multiplexeur comporte plusieurs entrées connectées aux connexions électriques 12, 13 des circuits de connexion 10 et une sortie couplée à une borne J8, J5 du système d'excitation C1. Plus particulièrement, chaque plaque bipolaire 100 est connectée électriquement directement aux deux moyens de sélection M+, M-, c'est-à-dire deux électrodes 5, 6 de deux étages 2 adjacents sont connectées électriquement aux deux moyens de sélection M+, M-. En outre, une première plaque monopolaire 101 est connectée électriquement au premier moyen de sélection M+ et une dernière plaque monopolaire 102 est connectée électriquement directement au deuxième moyen de sélection M-. En d'autres termes, une seule première électrode 5 située à la première extrémité de la pile 3, est couplée électriquement au premier moyen de sélection M+, et une seule deuxième électrode 6, située à la deuxième extrémité de la pile 3, est couplée électriquement au deuxième moyen de sélection M-.

En outre, un premier moyen de sélection M+ peut être couplé à une première borne J8 du système d'excitation C1 par l'intermédiaire d'une résistance R5, notée également résistance de dérivation ou de « shunt » en langue anglaise. En d'autres termes, la résistance de dérivation R5 à ses bornes couplées respectivement à la première borne J8 et à un noeud J9 couplé à la sortie du premier moyen de sélection M+. Selon un mode de réalisation, un premier moyen de sélection M+ a ses entrées connectées aux premières électrodes 5 de chacun des étages 2 de la pluralité de la pile 3, par l'intermédiaire des premières connexions électriques 12, et le deuxième moyen de sélection M- a ses entrées connectées aux deuxièmes électrodes 6 de chacun des étages 2 de la pluralité d'étages de la pile 3, par l'intermédiaire des deuxièmes connexions électriques 13.

Avantageusement, les moyens de sélection M+ M- peuvent être commandés, et le système de mesure 11 comporte une unité de commande électronique MCU, par exemple un microcontrôleur, un processeur ou un microprocesseur, configuré pour émettre des commandes CD1, CD2 à destination des moyens de sélection M+, M- afin de sélectionner un circuit de connexion 10. Lorsqu'un circuit de connexion 10 est sélectionné, on dit également que l'étage 2 associé est sélectionné. En d'autres termes, un étage 2 est sélectionné lorsque l'étage 2 forme avec le circuit de connexion associé 10 et le circuit d'excitation C1, un circuit fermé. En particulier, les moyens de sélection M+, M- sont commandés pour sélectionner un seul étage à la fois avant de déterminer l'impédance Zcell.

Par ailleurs, le système de mesure 11 est configuré pour appliquer à un étage sélectionné 2 un signal d'excitation généré par le système d'excitation C1. En outre, le système de mesure 11 est configuré pour mesurer un signal de réponse à l'application du signal d'excitation. Le signal de réponse peut être un courant de réponse ou d'une tension de réponse. La mesure du signal de réponse peut être effectuée par l'unité de commande électronique MCU. En particulier, l'unité de commande électronique MCU peut être connectée aux bornes de la résistance de dérivation R5, par l'intermédiaire de connexions 16, 17 connectées au noeud J9, et à la borne J8. Par ailleurs, l'unité de commande électronique MCU peut être connectée en aval des moyens de sélection M+, M-, par des connexions 18, 19 connectées à un noeud J6 et à la borne J5, le noeud J6 étant couplé à la sortie du premier moyen de sélection M+. Ainsi, l'unité de commande électronique MCU peut mesurer la tension de réponse d'un étage 2 sélectionné en mesurant la tension entre le noeud J6 et la borne J5. L'unité de commande électronique MCU peut également mesurer le courant de réponse d'un étage 2 sélectionné à partir de la tension mesurée entre le noeud J9 et la borne J8. Plus particulièrement, le signal d'excitation est un signal sinusoïdal et le signal de réponse est également sinusoïdal. L'unité de commande électronique MCU peut en outre comprendre des circuits de mesure aptes à mesurer le signal de réponse, c'est-à-dire le courant ou la tension de réponse. Les circuits de mesure comprennent, par exemple, un amplificateur, un filtre et un convertisseur analogique/numérique pour effectuer les mesures.

Par ailleurs, les variations du signal de réponse dépendent de l'impédance de l'étage 2 sélectionné, et plus particulièrement de l'état de la membrane 4 de l'étage 2. Ainsi, en mesurant le courant et/ou la tension de réponse, le système de mesure 11 peut déterminer l'impédance Zcell de l'étage 2 sélectionné. En particulier, le système de mesure 11 sélectionne un étage 2 à la fois pour déterminer l'impédance Zcell de l'étage 2. Le système de mesure 11 permet donc d'estimer l'état de la membrane 4 d'un étage 2 à partir de l'impédance Zcell ainsi déterminée. En outre, le système de mesure 11 peut estimer de manière plus précise l'état général de la pile 3 en déterminant l'impédance Zcell de tous les étages 2 de la pile 3.

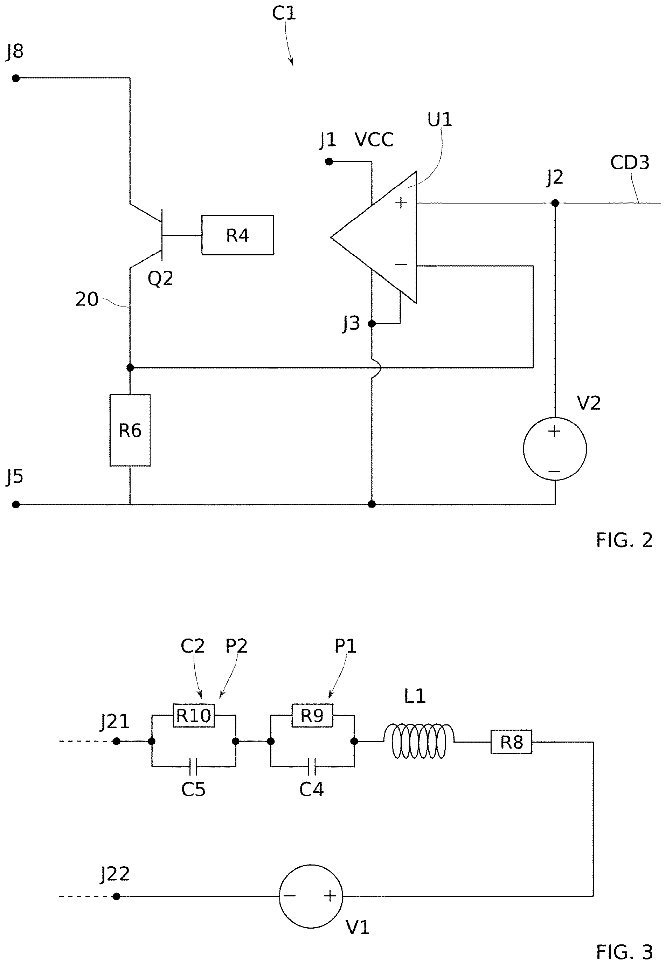

Sur la figure 2, on a représenté un mode de réalisation d'un système d'excitation C1.

Dans ce mode de réalisation, le système d'excitation C1 est un circuit électrique. Le système d'excitation C1 comprend une branche de décharge 20 comportant en série un transistor de puissance Q2, par exemple un transistor MOS ou un transistor bipolaire, et une résistance de décharge R6. Dans cet exemple le transistor Q2 est un transistor bipolaire de type NPN dont le collecteur est connecté à la première borne J8 et dont l'émetteur est connecté à la résistance de décharge R6. A titre de variante, un transistor PNP ou un transistor MOS peuvent être utilisés. Le système d'excitation C1 comprend en outre un amplificateur opérationnel U1 dont un noeud d'alimentation haute J1 est destiné à recevoir un premier potentiel d'alimentation VCC et dont un noeud d'alimentation basse J3 est destiné à recevoir un deuxième potentiel d'alimentation inférieur au premier potentiel. L'alimentation de l'amplificateur U1 peut provenir d'une source extérieure non représentée. De préférence, le potentiel d'alimentation VCC est fourni par une source d'alimentation indépendante de la pile à combustible 3. Dans l'exemple représenté, le noeud d'alimentation basse J3 est connecté au potentiel bas de l'étage 2 dont on souhaite mesurer l'impédance Zcell, c'est-à-dire par le potentiel du noeud J5. L'amplificateur U1 comprend une borne d'entrée inverseuse (-) connectée à l'émetteur du transistor Q2, et une borne de sortie connectée à la base du transistor Q2 par l'intermédiaire d'une résistance R4. Le circuit C1 comprend en outre un noeud J2 couplé au microcontrôleur MCU et à la borne d'entrée non inverseuse (+) de l'amplificateur opérationnel U1 de manière à transmettre une tension de commande CD3, issue du microcontrôleur MCU, vers l'amplificateur opérationnel U1. La tension de commande CD3 appliquée à l'amplificateur U1 permet de fermer ou d'ouvrir le transistor Q2, pour délivrer ou non le signal d'excitation à l'étage 2 sélectionné. En particulier, la tension de commande CD3 détermine le courant débité dans le transistor Q2 par l'étage 2 sélectionné. Le système d'excitation C1 comprend, en outre, une source d'alimentation V2 couplée entre le noeud J2 et la borne J5.

La branche de décharge 20 est connectée en parallèle aux bornes J8, J5 du système d'excitation C1. Les bornes J8, J5 du système d'excitation C1 sont couplées aux bornes de l'étage 2 sélectionné, par l'intermédiaire des moyens de sélection M+, M-, dont on souhaite mesurer l'impédance Zcell.

Afin d'améliorer l'estimation de l'état de la membrane 4 des étages de la pile 3, le système de mesure 11 peut être configuré pour améliorer la précision de la détermination de l'impédance Zcell des étages 2. La précision sur la détermination de l'impédance Zcell est d'autant plus pertinente que les valeurs mesurées en tension et/ou en courant sont faibles pour une pile à combustible 3, et notamment une pile à hydrogène. En effet, il apparait que les moyens de sélection M+, M- et les circuits de connexion 10 peuvent introduire des erreurs sur les mesures des signaux de réponse des étages 2. Plus particulièrement, l'impédance, surtout résistive, non nulle des moyens de sélection M+, M-en conduction, qui peut être de quelques ohms, peuvent dégrader la mesure des signaux de réponse et donc la détermination de l'impédance de la membrane 4. Par ailleurs, la longueur des connexions électriques 12, 13 entre les étages 2 et les moyens de sélection M+, M- introduit une erreur non négligeable. La température peut affecter la résistance des connexions électriques 12, 13. Par ailleurs, l'impédance des connexions électriques 12, 13 et celle des moyens de sélection M+, M- s'additionnent à celle de l'étage sélectionné 2 et perturbent donc la détermination de l'impédance Zcell de l'étage 2 sélectionné. Afin d'améliorer la précision de l'impédance Zcell, le système de mesure 11 peut être configuré pour compenser les erreurs introduites par les circuits de connexion 10 et les moyens de sélection M+, M-.

Le système de mesure 11 comprend en outre un circuit C2, dit circuit équivalent. Le circuit équivalent C2 est configuré pour avoir une impédance de référence Zref. L'impédance de référence Zref correspond à une impédance d'un étage 2 de la pile 3. On peut réaliser le circuit équivalent C2 à partir de modèles théoriques. Par exemple, on peut déterminer l'impédance Zcell d'un étage 2 lorsque la pile 3 est en fonctionnement, c'est-à-dire qu'elle produit une énergie électrique, avant son utilisation. Cette détermination peut être réalisée en usine. Puis, on réalise le circuit équivalent C2 pour obtenir un circuit ayant une impédance Zref la plus proche possible de celle déterminée préalablement Zcell.

Le circuit équivalent C2 est couplé électriquement aux moyens de sélection M+, M-, par l'intermédiaire de deux éléments électriquement conducteurs 22, 21 respectivement. Les éléments électriquement conducteurs 21, 22 peuvent être des câbles, des fils ou des bandes électriquement conducteurs, ou encore des pistes sur carte à circuits imprimée, par exemple sur une carte 30 où est réalisé le circuit équivalent C2. Les moyens de sélection M+, M- sont en outre aptes à sélectionner le circuit équivalent C2 en couplant électriquement le circuit équivalent C2 avec le système d'excitation C1. Le système de mesure 11 est en outre configuré pour :

- appliquer au circuit équivalent C2 un signal d'excitation généré par le système d'excitation C1 ;
- mesurer un signal de réponse du circuit équivalent C2 à l'application du signal d'excitation ;
- déterminer une impédance du circuit équivalent Zref_meas à partir du signal de réponse du circuit équivalent C2 ;
- calculer une erreur d'impédance ez à partir de l'impédance de référence Zref et de l'impédance déterminée du circuit équivalent Zref_meas.

Le système de mesure 11 est en outre configuré pour déterminer l'impédance de l'étage sélectionné Zcell à partir du signal en réponse et de l'erreur d'impédance ez.

Les connexions électriques 12, 13 des circuits de connexion 10 et les moyens de sélection M+, M- ont des résistances non nulles et introduisent une erreur ez sur la détermination de l'impédance Zcell de l'étage 2 sélectionné. On peut noter ez = efils + ems, où ez correspond à l'erreur d'impédance sur l'impédance déterminée Zcell d'un étage 2 sélectionné (en ohms), efils correspond à l'erreur d'impédance induite par les connexions électriques 12, 13, (en ohms), et ems l'erreur d'impédance induite par les moyens de sélection M+, M- (en ohms).

La détermination de l'impédance Zcell d'un étage 2 sélectionné peut être calculée selon l'équation (1) : Zcell_meas = Zcell + ez (1), où Zcell_meas correspond à l'impédance d'un étage 2 sélectionné avec une erreur de mesure (en ohms) et Zcell correspond à l'impédance d'un étage 2 sélectionné sans erreur.

Par ailleurs, la détermination de l'impédance du circuit équivalent Zref_meas à partir de la mesure du signal de réponse du circuit équivalent est impactée par les mêmes perturbations que la détermination de l'impédance de l'étage 2 sélectionne Zcell_meas à partir de la mesure du signal en réponse de l'étage 2. En outre, l'impédance de référence Zref du circuit équivalent C2 est connue, et on peut donc estimer l'impédance du circuit équivalent C2 en calculant l'équation (2) suivante : Zref_meas = Zref + ez (2), où Zref est l'impédance du circuit équivalent C2 (en ohms) et Zref_meas est l'impédance déterminée du circuit équivalent avec une erreur de mesure (en ohms). On considère que l'erreur d'impédance ez sur l'impédance déterminée Zcell d'un étage 2 sélectionné est la même que l'erreur d'impédance sur l'impédance déterminée Zref_meas du circuit équivalent C2. En effet, le système de mesure 11 utilise les mêmes moyens de sélection M+, M- et le même système d'excitation C1 pour à la fois déterminer Zcell et Zref_meas.

Ainsi, on peut déduire de l'équation (2), l'équation (3) suivante :

$$ez = Zref\_meas - Zref \ (3).$$

On peut déduire de l'équation (1), l'équation (4) suivante :

$$Zcell = Zcell\_meas - ez \ (4).$$

On peut donc déduire des équations (3) et (4), l'équation (5) suivante :

$$Zcell = Zcell\_meas - Zref\_meas + Zref \ (5).$$

La détermination de l'impédance Zref permet de soustraire l'erreur due aux connexions électriques 12, 13 et à l'impédance des moyens de sélection M+, M- sur la détermination de l'impédance Zcell de l'étage 2 sélectionné.

Ainsi en connaissant la valeur de Zref, puis en déterminant l'impédance d'un étage 2 sélectionné avec une erreur d'impédance Zcell_meas et en déterminant l'impédance du circuit équivalent C2 avec une erreur d'impédance Zref_meas, on détermine l'impédance de l'étage 2 sélectionné sans erreur Zcell.

Pour obtenir une détermination de l'impédance Zcell, la plus précise possible, il est préférable d'effectuer la détermination de l'impédance Zref_meas dans des conditions les plus proches possible que lors de la détermination de l'impédance Zcell. Ainsi, l'impédance de chacun des deux éléments 21, 22 peut être comprise entre 0,9 fois et 1,1 fois celle de chacun des deux connexions électriques 12, 13 des circuits de connexion 10. Avantageusement les éléments 21, 22 sont réalisés avec le même matériau que celui des connexions électriques 12, 13. De préférence, la section et la longueur de chacun des deux éléments 21, 22 est comprise entre 0,9 fois et 1,1 fois, de préférence identique, à celles de chacun des connexions électriques 12, 13. Il n'est pas nécessaire de minimiser la longueur des éléments électriquement conducteurs 21, 22 pour limiter les effets de résistance entre le circuit équivalent C2 et les moyens de sélection M+, M- afin de déterminer l'impédance Zcell la plus précise possible.

Sur la figure 3, on a représenté un mode de réalisation du circuit équivalent C2. Le circuit équivalent C2 comprend un ensemble de composants, R8, L1, C4, R9, C5, R10 ayant pour impédance, l'impédance de référence Zref.

8

En particulier, le circuit équivalent C2 comprend en série une source de tension V1, une résistance R8, une inductance L1 un premier circuit P1 ayant une capacité C4 montée en parallèle d'une résistance R9 et un deuxième circuit P2 ayant une capacité C5 montée en parallèle d'une résistance R10. En outre, le circuit équivalent C2 comprend une première borne J21 couplée au deuxième circuit P2 et à un premier élément électriquement conducteur 21 et une deuxième borne J22 couplée à la source de tension V1 et au deuxième élément électriquement conducteur J22. La source de tension V2 peut être un régulateur linéaire LDO (« Low-dropout regulators » en langue anglaise, ou régulateurs à faible courant de repos) avec une sortie à impédance faible, alimenté par la même tension qui alimente les autres composants du système de mesure 11. Ainsi, on évite de perturber la mesure du signal de réponse du circuit équivalent C2 lors de la détermination de l'impédance Zref_meas. Avantageusement, la source de tension V1 fournit une tension équivalente à celle fournie par un étage de la pile 3. Par exemple, la source V1 fournit une tension de 1V. Ainsi, l'erreur d'impédance ez est similaire lorsqu'on détermine l'impédance Zcell d'un étage 2 sélectionné et lorsqu'on détermine l'impédance du circuit équivalent Zref_meas. En d'autres termes les erreurs de mesure sont similaires lorsqu'on mesure les signaux de réponse des étages 2 sélectionnés et lorsqu'on mesure le signal de réponse du circuit équivalent C2.

Le système de mesure 11 est en outre configuré pour déterminer l'impédance d'un étage sélectionné Zcell périodiquement selon une première période et pour déterminer l'impédance du circuit équivalent Zcell_meas périodiquement selon une deuxième période inférieure ou égale à la première période.

Les éléments électriquement conducteurs 21, 22 du système de mesure 11 sont localisés à un emplacement qui leur permet d'être soumis à une température très proche de celle des connexions électriques 12, 13 du dispositif 1 de détermination d'impédance. Par exemple, en considérant ΔT°C la différence de température entre les connexions électriques 12, 13 de chaque circuit de connexion 10 et les éléments électriquement conducteurs 21, 22 couplés aux moyens de sélection (M+, M-) du circuit électrique équivalent C2, ΔT°C < 30°C, de préférence ΔT°C < 10°C.

De préférence, le système de mesure 11 est localisé à un emplacement tel qu'une température Tmeas de l'emplacement diffère de moins de 30°C et de préférence de moins de 10°C, d'une température Tcell de la pile à combustible 3 lors de son fonctionnement.

Par exemple, les deux éléments électriquement conducteurs 21, 22 empruntent au moins partiellement une zone où sont situées les connexions électriques 12, 13 d'au moins un circuit de connexion 10, pour que les éléments électriquement conducteurs 21, 22 et les connexions électriques 12, 13 soient situés dans un même environnement thermique.

Ainsi, les variations de température qui impactent l'impédance du système de mesure 11, en particulier celle des éléments électriquement conducteurs 21, 22, impactent de la même manière l'impédance Zref du circuit équivalent C2. La détermination de l'impédance de chaque étage 2 s'affranchie donc des variations d'impédance du circuit de mesure en fonction de la température.

Pour cela, le système de mesure 11 est localisé de sorte que la chaleur de la pile 3 soit, par conduction et/ou convection, transmise de la même manière aux connexions électriques 12, 13 de chaque circuit de connexion 10 et aux éléments électriquement conducteurs 21, 22 du circuit électrique équivalent C2.

Par exemple, le système de mesure peut être imprimé sur une carte de circuits imprimés 30. La carte 30 peut faire partie d'un système de contrôle de la pile 3, appelé également carte FCMS (« Fuel Cell Monitoring System » en langue anglaise, c'est-à-dire système de contrôle de la pile à combustible ») ou carte CVM (« Cell Voltage Monitor »), c'est-à-dire mesure de la tension d'un étage de la pile ou cellule. Ainsi, la carte 30 supportant le système de mesure peut être logée dans un boîtier.

En particulier, le système de contrôle mesure les tensions de la pile 3. La carte 30 peut être couplée de façon permanente à la pile 3. Le système de mesure 11 peut être alimenté par une source de tension, non représentée à des fins de simplification, indépendante de la pile à combustible 3. Ainsi, on peut utiliser une tension d'alimentation plus élevée que celle fournie par la pile 3. On peut donc alimenter facilement les différents composants et circuits du système de mesure 11. En outre, le système de mesure 11 ne perturbe pas le fonctionnement de la pile 3 lorsqu'on détermine l'impédance Zcell d'un étage 2.

Le système de mesure 11 est de préférence alimenté par une source d'alimentation, non représentée à des fins de simplification, indépendante de la pile à combustible 3.

Le système de mesure est en outre configuré pour déterminer l'impédance de l'étage sélectionné Zcell lorsque la pile à combustible fournit une énergie électrique. Avantageusement, la mesure d'impédance peut être effectuée pendant le fonctionnement normal de la pile, sans qu'il soit nécessaire d'arrêter ou de démonter la pile.

Un procédé de détermination d'impédance d'une pluralité d'étages 2 d'une pile à combustible 3 peut être mis en oeuvre par le dispositif défini ci-avant. En particulier, le procédé peut alterner une série de détermination de l'impédance Zcell de plusieurs étages 2 avec une ou plusieurs déterminations de l'impédance Zref_meas du circuit équivalent C2 afin de calculer une erreur d'impédance ez et pour prendre en compte l'erreur d'impédance calculée pour la détermination de l'impédance Zcell des étages 2. En d'autres termes, le procédé comprend une première mesure dans laquelle on mesure un signal de réponse d'un étage sélectionné 2 à l'application d'un signal d'excitation et une deuxième mesure dans laquelle on mesure un signal de réponse du circuit équivalent C2 à l'application du signal d'excitation. La deuxième mesure peut être effectuée avant ou après la première mesure.

Au vu de la description qui précède, il apparaît clairement que la solution proposée permet de déterminer l'état de santé d'une pile de manières significativement plus fiables que les solutions existantes.

L'invention n'est pas limitée aux seuls modes de réalisation décrits dans la description qui précède.

## Revendications

1. Dispositif de détermination d'impédance d'une pluralité d'étages (2) d'une pile à combustible (3), chaque étage de la pluralité d'étages (2) comprenant un électrolyte (4) placé entre deux électrodes (5, 6), le dispositif comprenant :

   - plusieurs circuits de connexion (10) associés respectivement aux étages de la pluralité d'étages (2), chaque circuit de connexion (10) étant électriquement couplé aux électrodes (5, 6) de l'étage (2) associé, et
   - un système de mesure (11) comprenant un système d'excitation (C1) commun à la pluralité d'étages (2), et des moyens de sélection (M+, M-) ;

   **caractérisé en ce que** le système de mesure (11) comporte un circuit (C2), dit circuit équivalent, ayant une impédance de référence (Zref) correspondant à celle d'un étage de la pluralité d'étages (2), **en ce que** les moyens de sélection (M+, M-) sont aptes à sélectionner un étage de la pluralité d'étages (2) en couplant électriquement le circuit de connexion (10) associé avec le système d'excitation (C1), les moyens de sélection (M+, M-) étant en outre aptes à sélectionner le circuit équivalent (C2) en couplant électriquement le circuit équivalent (C2) avec le système d'excitation (C1) ; et **en ce que** le système de mesure (11) est configuré pour :

   - appliquer à l'étage sélectionné un signal d'excitation généré par le système d'excitation (C1) ;
   - mesurer un signal de réponse de l'étage sélectionné à l'application du signal d'excitation ;
   - appliquer au circuit équivalent (C2) un signal d'excitation généré par le système d'excitation (C1) ;
   - mesurer un signal de réponse du circuit équivalent (C2) à l'application du signal d'excitation ;
   - déterminer une impédance du circuit équivalent (Zref_meas) à partir du signal de réponse du circuit équivalent (C2) ;
   - calculer une erreur d'impédance (ez) à partir de l'impédance de référence (Zref) et de l'impédance déterminée du circuit équivalent (Zref_meas), et
   - déterminer une impédance de l'étage sélectionné (Zcell) à partir du signal de réponse de l'étage sélectionné et de l'erreur d'impédance (ez).

2. Dispositif selon la revendication précédente, dans lequel le système de mesure (11) comprend une unité de commande électronique (MCU) et les moyens de sélection (M+, M-) comprennent au moins un multiplexeur commandé par l'unité de commande électronique (MCU).

3. Dispositif selon l'une des revendications 1 ou 2, dans lequel le circuit électrique équivalent (C2) comprend un ensemble de composants ayant pour impédance, l'impédance de référence (Zref), et une source de tension (V1) pour alimenter l'ensemble de composants, la source de tension (V1) fournissant une tension équivalente à celle fournie par un étage.

4. Dispositif selon l'une des revendications 1 à 3, dans lequel le système de mesure (11) est configuré pour déterminer l'impédance d'un étage sélectionné (Zcell) périodiquement selon une première période et pour déterminer l'impédance du circuit équivalent (Zref_meas) périodiquement selon une deuxième période inférieure ou égale à la première période.

5. Dispositif selon l'une des revendications précédentes, dans lequel chaque circuit de connexion (10) comprend deux fils électriquement conducteurs (12, 13) couplés aux moyens de sélection (M+, M-) et le circuit électrique équivalent (C2) comprend deux éléments électriquement conducteurs (21, 22) couplés aux moyens de sélection (M+, M-), la température des fils électriquement conducteurs (12, 13) couplés aux moyens de sélection (M+, M-) présentent un écart de température $\Delta T°C$ avec les éléments électriquement conducteurs (21, 22), tel que $\Delta T°C < 30°C$, de préférence $\Delta T°C < 10°C$.

6. Dispositif selon la revendication précédente, dans lequel les deux éléments électriquement conducteurs (21, 22) empruntent au moins partiellement une zone où sont situés les deux fils électriquement conducteurs (12, 13) d'au moins un circuit de connexion (10).

**7.** Dispositif selon l'une des revendications précédentes, dans lequel le système de mesure (11) est imprimé sur une carte de circuits imprimés (30).

**8.** Dispositif selon l'une des revendications précédentes, dans lequel chaque circuit de connexion (10) comprend deux fils électriquement conducteurs (12, 13) couplés aux moyens de sélection (M+, M-) et le circuit électrique équivalent (C2) comprend deux éléments électriquement conducteurs (21, 22) couplés aux moyens de sélection (M+, M-), l'impédance de chacun des deux éléments (21, 22) étant comprise entre 0,9 fois et 1,1 fois celle de chacun des deux fils (12, 13) des circuits de connexion (10).

**9.** Dispositif selon la revendication précédente, dans lequel la section et la longueur de chacun des deux éléments (21, 22) est comprise entre 0,9 fois et 1,1 fois, de préférence identique, à celles de chacun des deux fils (12, 13) des circuits de connexion.

**10.** Dispositif selon l'une des revendications précédentes, dans lequel le système de mesure (11) est alimenté par une source d'alimentation indépendante de la pile à combustible (3).

**11.** Assemblage, comprenant :

- une pile à combustible (3) comprenant une pluralité d'étages, chaque étage de la pluralité d'étages (2) comprenant un électrolyte placé entre deux électrodes ; et
- un dispositif de détermination de l'impédance de la pluralité d'étages (2) de la pile à combustible (3) selon l'une des revendications précédentes.

**12.** Procédé de détermination d'impédance d'une pluralité d'étages (2) d'une pile à combustible (3), chaque étage de la pluralité d'étages (2) comprenant un électrolyte placé entre deux électrodes, **caractérisé en ce que** le procédé comprend :

- une première mesure comportant :

  ◦ une sélection d'un étage en couplant électriquement les électrodes de l'étage avec un système d'excitation (C1) commun à la pluralité d'étages (2) ;
  ◦ une application à chaque étage sélectionné d'un signal d'excitation généré par le système d'excitation (C1) ; et
  ◦ une mesure d'un signal de réponse de l'étage sélectionné à l'application du signal d'excitation ;

- une deuxième mesure effectuée avant ou après la première mesure, la deuxième mesure comportant :

  ◦ une sélection d'un circuit, dit circuit équivalent (C2), ayant une impédance de référence (Zref) correspondant à celle d'un étage de la pluralité d'étages, en couplant électriquement le circuit équivalent (C2) avec le système d'excitation (C1) ;
  ◦ une application au circuit équivalent (C2) d'un signal d'excitation généré par le système d'excitation (C1) ; et
  ◦ une mesure d'un signal de réponse du circuit équivalent (C2) à l'application du signal d'excitation ;

le procédé comprenant, en outre :

- une détermination d'une impédance du circuit équivalent (Zref_meas) à partir du signal de réponse du circuit équivalent (C2) ;
- un calcul d'une erreur d'impédance (ez) à partir de l'impédance de référence (Zref) et de l'impédance déterminée du circuit équivalent (Zref_meas), et
- une détermination d'une impédance de l'étage sélectionné (Zcell) à partir du signal de réponse de l'étage sélectionné et de l'erreur d'impédance (ez).

**13.** Procédé selon la revendication précédente, comprenant une alimentation du circuit équivalent (C2) par une source d'alimentation (V1) indépendante de la pile à combustible (3).

**14.** Procédé selon l'une des revendications 12 à 13, comprenant une détermination périodique, selon une première période, de l'impédance d'un étage sélectionné (Zcell) et une détermination périodique, selon une deuxième période inférieure ou égale à la première période, de l'impédance du circuit équivalent (Zref_meas).

**15.** Procédé selon l'une des revendications 12 à 14, dans lequel la pile à combustible (3) produit de l'énergie électrique.

**Patentansprüche**

**1.** Vorrichtung zum Bestimmen der Impedanz einer Vielzahl von Stufen (2) einer Brennstoffzelle (3), wobei jede Stufe der Vielzahl von Stufen (2) einen Elektrolyt (4) umfasst, der zwischen zwei Elektroden (5, 6) platziert ist, wobei die Vorrichtung Folgendes umfasst:

- mehrere Verbindungsschaltungen (10), die jeweils den Stufen der Vielzahl von Stufen (2) zugeordnet sind, wobei jede Verbindungsschaltung (10) elektrisch mit den Elektroden (5, 6) der zugeordneten Stufe (2) gekoppelt ist, und
- ein Messsystem (11), das ein Erregungssystem (C1), das der Vielzahl von Stufen (2) gemeinsam ist, und Auswahlmittel (M+, M-) umfasst;

**dadurch gekennzeichnet, dass** das Messsystem (11) eine Schaltung (C2), als äquivalente Schaltung bezeichnet, umfasst, die eine Referenzimpedanz (Zref) aufweist, die der einer Stufe der Vielzahl von Stufen (2) entspricht, und dass die Auswahlmittel (M+, M-) dazu geeignet sind, eine Stufe der Vielzahl von Stufen (2) durch elektrisches Koppeln der Verbindungsschaltung (10), die dem Erregungssystem (C1) zugeordnet ist, auszuwählen, wobei die Auswahlmittel (M+, M-) außerdem dazu geeignet sind, die äquivalente Schaltung (C2) durch elektrisches Koppeln der äquivalenten Schaltung (C2) mit dem Erregungssystem (C1) auszuwählen; und dass das Messsystem (11) dazu konfiguriert ist:

- an die ausgewählte Stufe ein Erregungssignal anzulegen, das von dem Erregungssystem (C1) erzeugt wird;
- ein Antwortsignal der ausgewählten Stufe auf das Anlegen des Erregungssignals zu messen;
- an die äquivalente Schaltung (C2) ein Erregungssignal anzulegen, das von dem Erregungssystem (C1) erzeugt wird;
- ein Antwortsignal der äquivalenten Schaltung (C2) auf das Anlegen des Erregungssignals zu messen;
- eine Impedanz der äquivalenten Schaltung (Zref_meas) ausgehend von dem Antwortsignal der äquivalenten Schaltung (C2) zu bestimmen;
- einen Impedanzfehler (ez) ausgehend von der Referenzimpedanz (Zref) und der bestimmten Impedanz der äquivalenten Schaltung (Zref_meas) zu berechnen, und
- eine Impedanz der ausgewählten Stufe (Zcell) ausgehend von dem Antwortsignal der ausgewählten Stufe und dem Impedanzfehler (ez) zu bestimmen.

**2.** Vorrichtung nach dem vorstehenden Anspruch, wobei das Messsystem (11) eine elektronische Steuereinheit (MCU) umfasst, und die Auswahlmittel (M+, M-) mindestens einen Multiplexer umfassen, der von der elektronischen Steuereinheit (MCU) gesteuert wird.

**3.** Vorrichtung nach einem der Ansprüche 1 oder 2, wobei die äquivalente elektrische Schaltung (C2) eine Anordnung von Komponenten umfasst, die als Impedanz die Referenzimpedanz (Zref) aufweisen, und eine Spannungsquelle (V1) zum Versorgen der Anordnung von Komponenten, wobei die Spannungsquelle (V1) eine Spannung äquivalent zu der liefert, die von einer Stufe geliefert wird.

**4.** Vorrichtung nach einem der Ansprüche 1 bis 3, wobei das Messsystem (11) dazu konfiguriert ist, die Impedanz einer ausgewählten Stufe (Zcell) periodisch gemäß einer ersten Periode zu bestimmen, und um die Impedanz der äquivalenten Schaltung (Zref_meas) periodisch gemäß einer zweiten Periode, die kleiner oder gleich der ersten Periode ist, zu bestimmen.

**5.** Vorrichtung nach einem der vorstehenden Ansprüche, wobei jede Verbindungsschaltung (10) zwei elektrisch leitende Drähte (12, 13) umfasst, die mit den Auswahlmitteln (M+, M-) gekoppelt sind, und die äquivalente elektrische Schaltung (C2) zwei elektrisch leitende Elemente (21, 22) umfasst, die mit den Auswahlmitteln (M+, M-) gekoppelt sind, wobei die Temperatur der elektrisch leitenden Drähte (12, 13), die mit den Auswahlmitteln (M+, M-) gekoppelt sind, einen Temperaturunterschied $\Delta T°C$ zu den elektrisch leitenden Elementen (21, 22) derart aufweist, dass $\Delta T°C < 30\,°C$, bevorzugt $\Delta T°C < 10\,°C$.

**6.** Vorrichtung nach dem vorstehenden Anspruch, wobei die zwei elektrisch leitenden Elemente (21, 22) mindestens teilweise durch eine Zone führen, in der sich die zwei elektrisch leitenden Drähte (12, 13) mindestens einer Verbindungschaltung (10) befinden.

7. Vorrichtung nach einem der vorstehenden Ansprüche, wobei das Messsystem (11) auf einer Leiterplatte (30) gedruckt ist.

8. Vorrichtung nach einem der vorstehenden Ansprüche, wobei jede Verbindungsschaltung (10) zwei elektrisch leitende Drähte (12, 13) umfasst, die mit den Auswahlmitteln (M+, M-) gekoppelt sind, und die äquivalente elektrische Schaltung (C2) zwei elektrisch leitende Elemente (21, 22) umfasst, die mit den Auswahlmitteln (M+, M-) gekoppelt sind, wobei die Impedanz jedes der zwei Elemente (21, 22) zwischen dem 0,9-Fachen und 1,1-Fachen der jedes der zwei Drähte (12, 13) der Verbindungsschaltungen (10) liegt.

9. Vorrichtung nach dem vorstehenden Anspruch, wobei der Querschnitt und die Länge jedes der zwei Elemente (21, 22) zwischen dem 0,9-Fachen und 1,1-Fachen der jedes der zwei Drähte (12, 13) der Verbindungsschaltungen liegt, bevorzugt identisch ist.

10. Vorrichtung nach einem der vorstehenden Ansprüche, wobei das Messsystem (11) von einer Versorgungsquelle versorgt wird, die von der Brennstoffzelle (3) unabhängig ist.

11. Anordnung, die Folgendes umfasst:

   - eine Brennstoffzelle (3), die eine Vielzahl von Stufen umfasst, wobei jede Stufe der Vielzahl von Stufen (2) einen Elektrolyt umfasst, der zwischen zwei Elektroden platziert ist; und
   - eine Vorrichtung zum Bestimmen der Impedanz der Vielzahl von Stufen (2) der Brennstoffzelle (3) nach einem der vorstehenden Ansprüche.

12. Verfahren zum Bestimmen der Impedanz einer Vielzahl von Stufen (2) einer Brennstoffzelle (3), wobei jede Stufe der Vielzahl von Stufen (2) einen Elektrolyt umfasst, der zwischen zwei Elektroden platziert ist, **dadurch gekennzeichnet, dass** das Verfahren Folgendes umfasst:

   - eine erste Messung, die Folgendes umfasst:

      ◦ eine Auswahl einer Stufe durch elektrisches Koppeln der Elektroden der Stufe mit einem Erregungssystem (C1), das der Vielzahl von Stufen (2) gemeinsam ist;
      o ein Anlegen an jede ausgewählte Stufe eines Erregungssignals, das von dem Erregungssystem (C1) erzeugt wird; und
      o eine Messung eines Antwortsignals der ausgewählten Stufe auf das Anlegen des Erregungssignals;

   - eine zweite Messung, die vor oder nach der ersten Messung durchgeführt wird, wobei die zweite Messung Folgendes umfasst:

      ◦ eine Auswahl einer Schaltung, die als äquivalente Schaltung (C2) bezeichnet wird, die eine Referenzimpedanz (Zref) umfasst, die der einer Stufe der Vielzahl von Stufen entspricht, durch elektrisches Koppeln der äquivalenten Schaltung (C2) mit dem Erregungssystem (C1);
      ◦ ein Anlegen an die äquivalente Schaltung (C2) eines Erregungssignals, das von dem Erregungssystem (C1) erzeugt wird; und
      ◦ eine Messung eines Antwortsignals der äquivalenten Schaltung (C2) auf das Anlegen des Erregungssignals;

   wobei das Verfahren außerdem Folgendes umfasst:

   - ein Bestimmen einer Impedanz der äquivalenten Schaltung (Zref_meas) ausgehend von dem Antwortsignal der äquivalenten Schaltung (C2);
   - ein Berechnen eines Impedanzfehlers (ez) ausgehend von der Referenzimpedanz (Zref) und der bestimmten Impedanz der äquivalenten Schaltung (Zref_meas), und
   - ein Bestimmen einer Impedanz der ausgewählten Stufe (Zcell) ausgehend von dem Antwortsignal der ausgewählten Stufe und dem Impedanzfehler (ez).

13. Verfahren nach dem vorstehenden Anspruch, das eine Versorgung der äquivalenten Schaltung (C2) durch eine Versorgungsquelle (V1) umfasst, die von der Brennstoffzelle (3) unabhängig ist.

14. Verfahren nach einem der Ansprüche 12 bis 13, das eine periodische Bestimmung gemäß einer ersten Periode der Impedanz einer ausgewählten Stufe (Zcell) und eine periodische Bestimmung gemäß einer zweiten Periode, die kleiner oder gleich der ersten Periode ist, der Impedanz der äquivalenten Schaltung (Zref_meas) umfasst.

15. Verfahren nach einem der Ansprüche 12 bis 14, wobei die Brennstoffzelle (3) elektrischen Strom erzeugt.

**Claims**

1. Device for determining the impedance of a plurality of stages (2) of a fuel cell (3), each stage of the plurality of stages (2) comprising an electrolyte (4) placed between two electrodes (5, 6), the device comprising:

   - several connecting circuits (10) associated respectively with the stages of the plurality of stages (2), each connecting circuit (10) being electrically coupled to the electrodes (5, 6) of the associated stage (2), and
   - a measuring system (11) comprising an excitation system (C1) common to the plurality of stages (2), and selection means (M+, M-);

   **characterised in that** the measuring system (11) comprises a circuit (C2), called equivalent circuit, having a reference impedance (Zref) corresponding to that of a stage of the plurality of stages (2), **in that** the selection means (M+, M-) are capable of selecting a stage from the plurality of stages (2), by electrically coupling the connecting circuit (10) associated with the excitation system (C1), the selection means (M+, M-) further being capable of selecting the equivalent circuit (C2) by electrically coupling the equivalent circuit (C2) with the excitation system (C1); and **in that** the measuring system (11) is configured to:

   - apply to the selected stage, an excitation signal generated by the excitation system (C1);
   - measure a response signal from the selected stage to the application of the excitation signal;
   - apply to the equivalent circuit (C2), an excitation signal generated by the excitation system (C1);
   - measure a response signal from the equivalent circuit (C2) to the application of the excitation signal;
   - determine an impedance of the equivalent circuit (Zref_meas) from the response signal of the equivalent circuit (C2);
   - calculate an impedance error (ez) from the reference impedance (Zref) and from the impedance determined from the equivalent circuit (Zref_meas), and
   - determine an impedance of the selected stage (Zcell) from the response signal of the selected stage and of the impedance error (ez).

2. Device according to the preceding claim, wherein the measuring system (11) comprises an electronic control unit (MCU) and the selection means (M+, M-) comprise at least one multiplexer controlled by the electronic control unit (MCU).

3. Device according to one of claims 1 or 2, wherein the equivalent electric circuit (C2) comprises a set of components having as impedance, the reference impedance (Zref), and a voltage source (V1) to supply the set of components, the voltage source (V1) supplying a voltage equivalent to that supplied by a stage.

4. Device according to one of claims 1 to 3, wherein the measuring system (11) is configured to determine the impedance of a selected stage (Zcell) periodically according to a first period and to determine the impedance of the equivalent circuit (Zref_meas) periodically according to a second period less than or equal to the first period.

5. Device according to one of the preceding claims, wherein each connecting circuit (10) comprises two electrically conductive wires (12, 13) coupled to the selection means (M+, M-) and the equivalent electric circuit (C2) comprises two electrically conductive elements (21, 22) coupled to the selection means (M+, M-), the temperature of the electrically conductive wires (12, 13) coupled to the selection means (M+, M-) have a temperature difference $\Delta T°C$ with the electrically conductive elements (21, 22), such that $\Delta T°C < 30°C$, preferably $\Delta T°C < 10°C$.

6. Device according to the preceding claim, wherein the two electrically conductive elements (21, 22) at least partially use a zone where the two electrically conductive wires (12, 13) of at least one connecting circuit (10) are located.

7. Device according to one of the preceding claims, wherein the measuring system (11) is printed on a printed circuit board (30).

8. Device according to one of the preceding claims, wherein each connecting circuit (10) comprises two electrically conductive wires (12, 13) coupled to the selection means (M+, M-) and the equivalent electric circuit (C2) comprises two electrically conductive elements (21, 22) coupled to the selection means (M+, M-), the impedance of each of the two elements (21, 22) being between 0.9 times and 1.1 times that of each of the two wires (12, 13) of the connecting circuits (10).

9. Device according to the preceding claim, wherein the cross-section and the length of each of the two elements (21, 22) is between 0.9 times and 1.1 times, preferably identical, to those of each of the two wires (12, 13) of the connecting circuit.

10. Device according to one of the preceding claims, wherein the measuring system (11) is supplied by a power source independent from the fuel cell (3).

11. Assembly, comprising:

- a fuel cell (3) comprising a plurality of stages, each stage of the plurality of stages (2) comprising an electrolyte placed between two electrodes; and
- a device for determining the impedance of the plurality of stages (2) of the fuel cell (3) according to one of the preceding claims.

12. Method for determining the impedance of a plurality of stages (2) of a fuel cell (3), each stage of the plurality of stages (2) comprising an electrolyte placed between two electrodes, **characterised in that** the method comprises:

- a first measurement comprising:

    ◦ a selection of a stage by electrically coupling the electrodes of the stage with an excitation system (C1) common to the plurality of stages (2);
    ◦ an application to each selected stage of an excitation signal generated by the excitation system (C1); and
    ◦ a measurement of a response signal of the selected stage to the application of the excitation signal;

- a second measurement taken before or after the first measurement, the second measurement comprising:

    ◦ a selection of a circuit, called equivalent circuit (C2), having a reference impedance (Zref) corresponding to that of a stage of the plurality of stages, by electrically coupling the equivalent circuit (C2) with the excitation system (C1);
    ◦ an application to the equivalent circuit (C2) of an excitation signal generated by the excitation system (C1); and
    ◦ a measurement of a response signal from the equivalent circuit (C2) to the application of the excitation signal;

the method further comprising:

- a determination of an impedance of the equivalent circuit (Zref_meas) from the response signal of the equivalent circuit (C2);
- a calculation of an impedance error (ez) from the reference impedance (Zref) and of the impedance determined from the equivalent circuit (Zref_meas), and
- a determination of an impedance of the selected stage (Zcell) from the response signal of the selected stage and of the impedance error (ez).

13. Method according to the preceding claim, comprising a supply of the equivalent circuit (C2) by a supply source (V1) independent from the fuel cell (3).

14. Method according to one of claims 12 to 13, comprising a periodic determination, according to a first period, of the impedance of a selected stage (Zcell) and a periodic determination, according to a second period less than or equal to the first period of the impedance of the equivalent circuit (Zref_meas).

**15.** Method according to one of claims 12 to 14, wherein the fuel cell (3) produces electric energy.

FIG. 1

C1

J8

J1  VCC  U1

J2  CD3

R4

Q2

20

J3

R6

J5

V2

**FIG. 2**

C2  P2  P1

J21  R10  R9  L1  R8

C5  C4

J22

V1

**FIG. 3**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- CN 109916964
- US 2019049522 A
- US 2010323260 A
- CN 111077467 A